# EUROPÄISCHE PATENTSCHRIFT

(11) **EP 0 383 968 B1**
(45) Veröffentlichungstag und Bekanntmachung des Hinweises auf die Patenterteilung: **12.01.1994**
(21) Anmeldenummer: 89103063.7
(22) Anmeldetag: 22.02.1989
(51) Int. Cl.: H03F 3/19, H04N 5/14

(54) **Schaltungsanordnung für eine Verstärkerstufe**
Amplifier stage circuit
Circuit d'un étage amplificateur

(43) Veröffentlichungstag der Anmeldung: 29.08.1990
(73) Patentinhaber: SIEMENS AKTIENGESELLSCHAFT, 80333 München (DE)
(72) Erfinder: Kaifler, Erich, Dipl.-Ing. (FH), D-8028 Taufkirchen (DE); Grobecker, Horst, Dipl.-Ing., D-8000 München 83 (DE)

(56) Entgegenhaltungen:
- US-A- 3 681 619
- HALBLEITER-SCHALTUNGSTECHNIK, 7. Aufl., S. 162-166, 1985, U. Tietze u. C. Schenk
- ELECTRONIC ENGENEERING; Bd. 53, Nr. 647, Januar 1981, S. 59-65, London, GB; M.A. Rehmann:"Mosfet analog integrated circuits"
- ELEKTRONIK, Heft 9, April 1987, S. 120-124; D. Vogel: "IGBT hochsperrende schnell schaltende Transistormodule"

## Beschreibung

Die Erfindung betrifft eine Schaltungsanordnung für eine Verstärkerstufe nach dem Oberbegriff des Anspruchs 1.

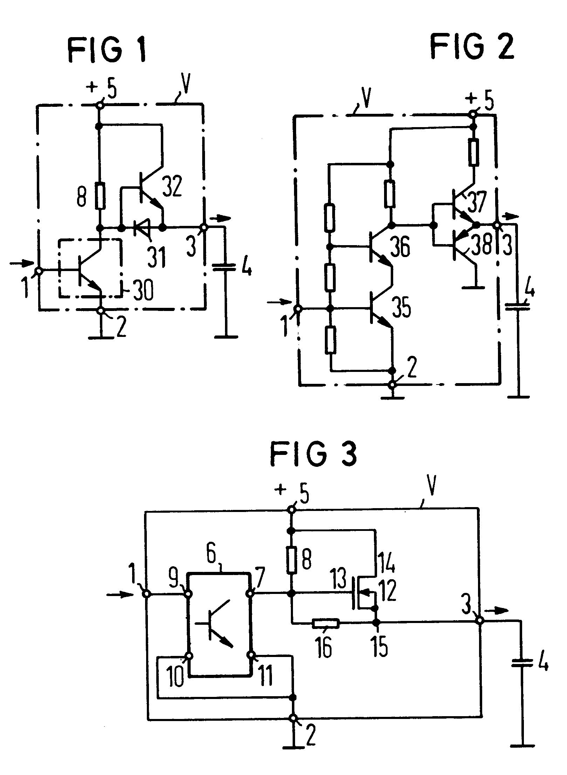

Eine solche Schaltungsanordnung ist in FIG 1 dargestellt und z. B. aus dem Buch "Halbleiter-Schaltungstechnik" von U. Tietze und CH. Schenk, 1980, 5. Auflage, Seite 131, Abbildung 8.6 bekannt. Diese Schaltungsanordnung weist einen ein Eingangssignal verstärkenden Verstärkervierpol in Form eines in Emitterschaltung angeordneten Bipolartransistors auf, dessen Emitteranschluß mit einer Bezugspotentialklemme 1 und dessen Kollektoranschluß über einen Widerstand 8 mit einer Versorgungsspannungsklemme 5 in Verbindung steht. Der Basisanschluß dieses Bipolartransistors 30 ist mit der Eingangsklemme 1 der Verstärkerstufe V verbunden. Weiterhin ist an den Verbindungspunkt des Widerstandes 8 und dem Kollektoranschluß des Bipolartransistors 30 der Kathodenanschluß einer Diode 31 und der Basisanschluß eines weiteren Bipolartransistors 32 angeschlossen. Der Kathodenanschluß dieses weiteren Bipolartransistors 32 ist mit der Versorgungsspannungsquelle 5 in Kontakt, während der Emitteranschluß und der Anodenanschluß der Diode 31 mit der Ausgangsklemme 3 der Verstärkerstufe V verbunden sind. Zwischen Bezugspotential und dieser Ausgangsklemme 3 ist eine kapazitive Last 4, wie z. B die Bildröhre eines Bildschirmgerätes, angeschlossen.

Mit dieser auch unter dem Begriff "Aktivlast-Schaltung" bekannten Schaltungsanordnung kann die kapazitive Last 4 beschleunigt aufgeladen werden. Dies wird insbesondere dadurch erreicht, daß bei negativ gerichteten Impulsen an der Eingangsklemme 1 - das führt zu positiv gerichteten Impulsen an der Ausgangsklemme 3 - der erste Bipolartransistor 30 sperrt und damit dessen Kollektorpotential ansteigt. Dadurch wird die Diode 31 gesperrt und so das Emitterpotential des zweiten Bipolartransistors 32 zunächst festgehalten, während gleichzeitig dessen Basispotential erhöht wird. Dies bewirkt einen Anstieg des Basisstromes im zweiten Bipolartransistor 32 und damit einen um den Stromverstärkungsfaktor vergrößerten Kollektorstrom, der zu einer beschleunigten Aufladung der kapazitiven Last 4 führt. Diese Schaltung ist insbesondere als Videoendstufe zur Ansteuerung einer Bildröhre mit einer Zeilenfrequenz von 16 kHz geeignet. Es hat sich jedoch herausgestellt, daß die Verstärkung breitbandigerer Eingangssignale mit dieser bekannten Schaltungsanordnung nicht mehr zufriedenstellend ist.

Eine Schaltungsanordnung für eine Videoverstärkerendstufe zum Ansteuern einer Bildröhre mit 32 kHz-Zeilenfrequenz ist in FIG 2 dargestellt. Diese Schaltungsanordnung besteht im wesentlichen aus einer Kaskodeschaltung mit zwei Bipolartransistoren 35, 36 an deren Ausgang ein komplementärer Emitterfolger, bestehend aus zwei weiteren Bipolartransistoren 37, 38, angeschlossen ist. Zwischen Bezugspotential und Ausgang dieser komplementären Emitterfolgerschaltung ist die kapazitive Last 4 der Bildröhre angeordnet. Zum Verarbeiten hochfrequenter Eingangssignale ist es weiterhin vorteilhaft, die in FIG 2 dargestellte Schaltungsanordnung um sogenannte Beschleunigungsnetzwerke zu ergänzen. Dies kann z. B. dahingehend geschehen, daß zwischen den Emitteranschluß des Eingangstransistors 35 der Kaskodeschaltung und Bezugspotential ein RC-Netzwerk angeordnet wird, oder dadurch, daß zwischen dem Kollektoranschluß des Ausgangstransistors 36 der Kaskodeschaltung und dem positiven Pol der Gleichspannungsquelle ein LC-Netzwerk angeordnet wird.

Der vorliegenden Erfindung liegt die Aufgabe zugrunde, eine Schaltungsanordnung für eine breitbandige Verstärkerstufe, insbesondere zum Einsatz als Videoendstufe, anzugeben, die mit wenigen Bauelementen einfach zu realisieren und hinsichtlich der Schaltzeiten auch bei höherfrequenten Eingangssignalen unkritisch ist.

Diese Aufgabe wird durch die kennzeichnenden Merkmale des Anspruchs 1 gelöst.

Weiterbildungen der Erfindung sind Gegenstand der Unteransprü che.

Die Erfindung wird im folgenden anhand von weiteren vier Figuren näher erläutert. Es zeigen:
- FIG 1: eine bekannte Schaltungsanordnung einer bekannten Verstärkerstufe mit Aktivlast,
- FIG 2: eine bekannte Schaltungsanordnung einer Verstärkerstufe mit Kaskodeschaltung und nachgeschaltetem komplementären Emitterfolger,
- FIG 3: ein Prinzipschaltbild der erfindungsgemäßen Schaltungsanordnung,
- FIG 4: eine erfindungsgemäße Schaltungsanordnung einer Verstärkerstufe mit Bipolartransistor,
- FIG 5: eine erfindungsgemäße Schaltungsanordnung einer Verstärkerstufe mit Enhancement-MOS-FET, und
- FIG 6: eine erfindungsgemäße Schaltungsanordnung einer Verstärkerstufe mit einem IGBT-Transistor.

In FIG 3 ist das Prinzipschaltbild der erfindungsgemäßen Schaltungsanordnung dargestellt. Die Verstärkerstufe V weist neben einer Eingangsklemme 1 zum Anlegen eines Eingangsssignales eine Ausgangsklemme 3, eine Versorgungsspannungsklemme 5 zum Anschluß einer Gleichspannung und eine Bezugspotentialklemme 2 auf. Zwischen die Bezugspotentialklemme 2 und der Ausgangsklemme 3 ist eine kapazitive Last 4, z. B. die Bildröhre eines Bildschirmgerätes, angeschlossen. Abhängig vom an der Eingangsklemme 1 anliegenden Eingangssignal wird diese kapazitive Last 4 aufgeladen oder entladen.

Die Verstärkerstufe V weist im einzelnen dazu einen das Eingangssignal verstärkenden Verstärkervierpol 6 auf. Dieser Verstärkervierpol 6 ist mit einem ersten Eingangsanschluß 9, einem zweiten Eingangsanschluß 10, einem ersten Ausgangsanschluß 7 sowie einem zweiten Ausgangsanschluß 11 versehen Der erste Eingangsanschluß 9 dieses Verstärkervierpols ist mit der Eingangsklemme 1 der Verstärkerstufe V, an die das Eingangssignal anzulegen ist, verbunden. Der zweite Eingangsanschluß 10 und der zweite Ausgangsanschluß 11 des Verstärkervierpols 6 sind mit der Bezugspotentialklemme 2 in Verbindung. Zwischen der Versorgungsspannungsklemme 5, an die der positive Pol einer Gleichspannungsquelle anzuschließen ist, und dem ersten Ausgangsanschluß 7 des Verstärkervierpols 6 ist ein erster ohmscher Widerstand 8 angeordnet. Ein weiterer Transistor 12, gemäß der vorliegenden Erfindung ein selbstleitender n-Kanal-FET, ist mit seinem Gateanschluß 13 mit dem ersten Ausgangsanschluß 7 des Verstärkervierpols 6, mit seinem Drainanschluß 14 mit der Versorgungsspannungsklemme 5 und mit seinem Sourceanschluß 15 mit der Ausgangsklemme 3 der Verstärkerstufe V verbunden. Weiterhin ist zwischen dem Gateanschluß 13 und dem Sourceanschluß 15 dieses selbstleitenden FET 12 ein zweiter ohmscher Widerstand 16 angeordnet.

Zur Arbeitspunkteinstellung des Verstärkervierpols 6 ist es zweckmäßig, diesen mit einer stromabhängigen Spannungsgegenkopplung zu versehen. Mit der erfindungsgemäßen Schaltungsanordnung nach FIG 3 ist es möglich, die kapazitive Last 4, die bei einem Anschluß einer Bildröhre eines Bildschirmgerätes z. B. in der Größenordnung 10 pF liegt, schnell umzuladen. Ein weiterer Vorteil liegt vor allem im besseren Temperaturverhalten dieser erfindungsgemäßen Schaltungsanordnung. So kann durch die Verwendung eines selbstleitenden FET und insbesondere eines Depletion-MOS-FET oder vertikalen Depletion-MOS-FET der Widerstand 8 wesentlich hochohmiger dimensioniert werden, als dies in der Schaltungsanordnung nach FIG 1 der Fall ist. Damit wird die Verlustleistung in der Verstärkerstufe 6 wirksam reduziert.

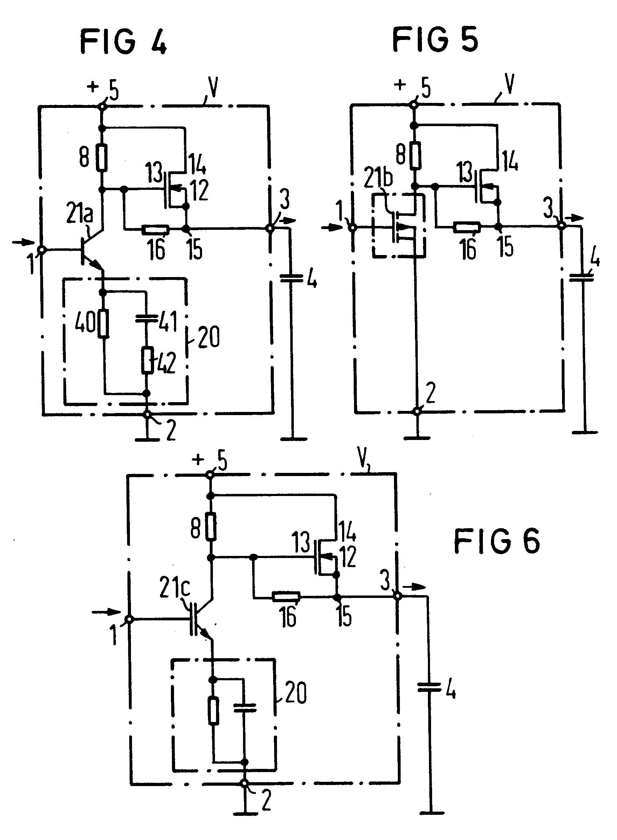

In FIG 4 ist die erfindungsgemäße Schaltungsanordnung dargestellt, wie sie sich ergibt, wenn als Verstärkervierpol 6 ein Bipolartransistor 21a mit stromabhängiger Spannungsgegenkopplung verwendet wird. Dazu ist der Bipolartransistor 21a mit der Eingangsklemme 1 der Schaltungsanordnung und der Kollektoranschluß mit dem Verbindungspunkt der Widerstände 8 und 16 verbunden. Der Emitteranschluß des Bipolartransistors 21a ist über ein zur stromabhängigen Spannungsgegenkopplung dienendes RC-Netzwerk, bestehend z. B. aus dem Widerstand 40 mit parallelgeschalteter Reihenschaltung aus einem Kondensator 41 und einem Widerstand 42, an die Bezugspotentialklemme 2 angeschlossen. Als selbstleitender FET 12 ist ein n-Depletion-MOS-FET vorgesehen. Bei einer Dimensionierung der Widerstände 8 mit z. B. 30 kOhm und des Widerstandes 16 mit 0,31 kOhm bei einer kapazitiven Last von 10 pF zieht der n-Kanal-Depletion-MOS-FET 12 im Ruhezustand etwa 1 mA und wirkt als Konstantstromquelle. Soll die kapazitive Last 4 aufgeladen werden, steigt dieser Strom auf etwa 100 mA an, weil das Potential am Verbindungspunkt der Widerstände 8 und 16 infolge des ausgeschalteten Bipolartransistors 21a ebenfalls ansteigt. Insgesamt führt diese erfindungsgemäße Schaltungsanordnung zu einer Reduzierung der Anstiegszeit des Bipolartransistors 21a und damit zum beschleunigten Umladen der kapazitiven Last 4.

FIG 5 zeigt die erfindungsgemäße Schaltungsanordnung mit einem p-Kanal-Enhancement-MOS-FET 21b. Der Gateanschluß dieses p-Kanal-Enhancement-MOS-FET 21b ist mit der Eingangsklemme 1 und der Drainanschluß mit dem Verbindungspunkt der Widerstände 8 und 16 verbunden. Der Sourceanschluß dieses MOS-FET 21b ist direkt mit der Bezugspotentialklemme 2 in Kontakt. Es ist jedoch auch hier möglich, eine stromabhängige Spannungsgegenkopplung nach Art der in FIG 4 dargestellten Spannungsgegenkopplung vorzusehen.

Die in FIG 6 dargestellte Schaltungsanordnung unterscheidet sich von den in FIG 4 und 5 dargestellten Schaltungsanordnungen lediglich darin, daß der Verstärkervierpol durch einen sogenannten IGBT (Insulated Gate Bipolartransistor) ersetzt ist, wie dieser z. B. aus Elektronik, Heft 9, 1987 auf Seite 120 bis 124 bekannt ist.

Mit der erfindungsgemäßen Schaltungsanordnung wird erreicht, daß der Verstärkungsbetrag, bezogen auf die Verstärkung bei 1 MHz, erst bei etwa 10 MHz um 3 dB abfällt. Bei dieser als Videobandbreite definierten Frequenz weist die Verstärkung demnach noch den 0,707fachen Wert der Verstärkung bei Eingangssignalen von 1 MHz auf. Die erfindungsgemäße Schaltungsanordnung kann daher bevorzugt als Videoendstufe zur Ansteuerung von Bildröhren mit einer Zeilenfrequenz von 16 kHz, aber auch 32 kHz eingesetzt werden.

## Patentansprüche

1. Schaltungsanordnung für eine Verstärkerstufe mit mindestens:
1.1. eine Eingangsklemme (1) zum Anlegen eines Eingangssignales;
1.2 eine Ausgangsklemme (3);
1.3 eine Versorgungsspannungsklemme (5) zum Anschluß einer Gleichspannung;
1.4 mindestens eine Bezugspotentialklemme (2);
1.5 eine zwischen die Ausgangsklemme (3) und die Bezugspotentialklemme (2) anzuschließende kapazitive Last (4);
1.6 ein das Eingangssignal verstärkender Verstärkervierpol (6), dessen erster Ausgangsanschluß (7) über mindestens einen ohmschen Widerstand (8) mit der Versorgungsspannungsklemme (5) verbunden ist, einen ersten mit der Eingangsklemme (1) verbundenen Eingangsanschluß (9) sowie einen zweiten Eingangsanschluß (10) und zweiten Ausgangsanschluß (11), die an die Bezugspotentialklemme (2) angeschlossen sind;
1.7. mindestens einen zwischen den ersten Ausgangsanschluß (7) und die Ausgangsklemme (3) geschalteten Transistor (12) zum beschleunigten Aufladen der kapazitiven Last (4),
**gekennzeichnet**
durch die Merkmale:
1.8. der Transistor (12) ist ein selbstleitender FET, dessen Gateanschluß (13) mit der ersten Ausgangsklemme (7), dessen Drainanschluß (14) mit der Versorgungsspannungsklemme (5) und dessen Sourceanschluß (15) mit der Ausgangsklemme (3) verbunden ist und
1.9. mindestens einen zwischen dem Gateanschluß (13) und Sourceanschluß (15) des FET angeschlossenen ohmschen Widerstand (16).

2. Schaltungsanordnung nach Anspruch 1,
**dadurch gekennzeichnet,**
daß der selbstleitende FET ein Depletion-MOS-FET ist.

3. Schaltungsanordnung nach Anspruch 1 oder 2,
**dadurch gekennzeichnet,**
daß der Vierpolverstärker (6) eine stromabhängige Spannungsrückkopplung (20) aufweist.

4. Schaltungsanordnung nach einem der Ansprüche 1 bis 3,
**dadurch gekennzeichnet,**
daß der Vierpolverstärker (6) mindestens einen verstärkenden Transistor (21) aufweist, dessen Steuerstrecke zwischen den Eingangsanschlüssen (9, 10) und dessen Laststrecke zwischen den Ausgangsanschlüssen (7, 11) angeordnet worden ist.

5. Schaltungsanordnung nach Anspruch 4,
**dadurch gekennzeichnet,**
daß der Transistor (21) des Vierpolverstärkers (6) ein Bipolartransistor (21a) ist.

6. Schaltungsanordnung nach Anspruch 4,
**dadurch gekennzeichnet,**
daß der Transistor (21) des Vierpolverstärkers (6) ein Enhancement-MOS-FET (21b) ist.

7. Schaltungsanordnung nach Anspruch 4,
**dadurch gekennzeichnet,**
daß der Transistor (21) des Vierpolverstärkers (6) ein IGBT (21c) ist.

8. Schaltungsanordnung nach einem der Ansprüche 1 bis 7,
**gekennzeichnet,**
durch die Verwendung als Videoverstärkerendstufe, dessen kapazitive Last (4) eine Bildröhre ist.

9. Schaltungsanordnung nach Anspruch 8,
**dadurch gekennzeichnet,**
daß die Bildröhre mit einem eine Zeilenfrequenz von 16 kHz aufweisenden Videosignal ansteuerbar ist.

10. Schaltungsanordnung nach Anspruch 8,
**dadurch gekennzeichnet,**
daß die Bildröhre mit einem eine Zeilenfrequenz von 32 kHz aufweisenden Videosignal ansteuerbar ist.

## Claims

1. Circuit arrangement for an amplifier stage having at least:
1.1 an input terminal (1) for the application of an input signal;
1.2 an output terminal (3);
1.3 a supply-voltage terminal (5) for the connection of a DC voltage;
1.4 at least one reference-potential terminal (2);
1.5 a capacitive load (4) which is to be connected between the output terminal (3) and the reference-potential terminal (2);
1.6 an amplifier four-pole network (6) which amplifies the input signal and whose first output connection (7) is connected via at least one resistor (8) to the supply-voltage terminal (5), a first input connection (9) which is connected to the input terminal (1), as well as a second input connection (10) and a second output connection (11) which are connected to the reference-potential terminal (2);
1.7 at least one transistor (12) which is connected between the first output connection (7) and the output terminal (3) for accelerated charging of the capacitive load (4),
characterized by the following features:
1.8 the transistor (12) is a normally-on FET whose gate connection (13) is connected to the first output terminal (7), whose drain connection (14) is connected to the supply-voltage terminal (5) and whose source connection (15) is connected to the output terminal (3), and
1.9 at least one resistor (16) which is connected between the gate connection (13) and the source connection (15) of the FET.

2. Circuit arrangement according to Claim 1, characterized in that the normally-on FET is a depletion-MOSFET.

3. Circuit arrangement according to Claim 1 or 2, characterized in that the four-pole network amplifier (6) has current-dependent voltage feedback (20).

4. Circuit arrangement according to one of Claims 1 to 3, characterized in that the four-pole network amplifier (6) has at least one amplifying transistor (21) whose control path has been arranged between the input connections (9, 10) and whose load path has been arranged between the output connections (7, 11).

5. Circuit arrangement according to Claim 4, characterized in that the transistor (21) of the four-pole network amplifier (6) is a bipolar transistor (21a).

6. Circuit arrangement according to Claim 4, characterized in that the transistor (21) of the four-pole network amplifier (6) is an enhancement-MOSFET (21b).

7. Circuit arrangement according to Claim 4, characterized in that the transistor (21) of the four-pole network amplifier (6) is an IGBT (21c).

8. Circuit arrangement according to one of Claims 1 to 7, characterized by use as a video-amplifier output stage whose capacitive load (4) is a picture tube.

9. Circuit arrangement according to Claim 8, characterized in that the picture tube can be driven by a video signal which has a line frequency of 16 kHz.

10. Circuit arrangement according to Claim 8, characterized in that the picture tube can be driven by a video signal which has a line frequency of 32 kHz.

## Revendications

1. Montage pour un étage amplificateur comportant au moins :
1.1. une borne d'entrée (1) pour l'application d'un signal d'entrée;
1.2 une borne de sortie (3);
1.3 une borne de tension d'alimentation (5) pour le raccordement d'une tension continue;
1.4 au moins une borne de potentiel de référence (2);
1.5 une charge capacitive (4) à brancher entre la borne de sortie (3) et la borne de potentiel de référence (2);
1.6 un quadripôle amplificateur (6) amplifiant le signal d'entrée, dont le premier raccordement de sortie (7) est reliée, par l'intermédiaire d'au moins une résistance ohmique (8), à la borne de tension d'alimentation (5), dont un premier raccordement d'entrée (9) est relié à la borne d'entrée (1) et dont un deuxième raccordement d'entrée (10) et un deuxième raccordement de sortie (11) sont reliés à la borne de potentiel de référence (2);
1.7 au moins un transistor (12), qui est monté entre le premier raccordement de sortie (7) et la première borne de sortie (3) et qui sert à charger de façon accélérée la charge capacitive (4),
caractérisé par les particularités suivantes:
1.8. le transistor (12) est un FET (transistor à effet de champ) autoconducteur, dont le raccordement de grille (13) est relié à la première borne de sortie (7), dont le raccordement de drain (14) est relié à la borne de tension d'alimentation (5) et dont le raccordement de source (15) est relié à la borne de sortie (3), et
1.9. au moins une résistance ohmique (16) est montée entre le raccordement de grille (13) et le raccordement de source (15) du FET.

2. Montage suivant la revendication 1,
caractérisé en ce que le FET autoconducteur est un MOS-FET à appauvrissement.

3. Montage suivant la revendication 1 ou 2,
caractérisé en ce que l'amplificateur quadripôle (6) comporte un circuit de contre-réaction en tension (20) dépendant du courant.

4. Montage suivant l'une des revendications 1 à 3,
caractérisé en ce que l'amplificateur quadripôle (6) comporte au moins un transistor (21) amplificateur dont la section de commande est disposée entre les raccordements d'entrée (9,10) et dont la section de charge est disposée entre les raccordements de sortie (7,11).

5. Montage suivant la revendication 4,
caractérisé en ce que le transistor (21) de l'amplificateur quadripôle (6) est un transistor bipolaire (21a).

6. Montage suivant la revendication 4,
caractérisé en ce que le transistor (21) de l'amplificateur quadripôle (6) est un MOS-FET à enrichissement (21b).

7. Montage suivant la revendication 4,
caractérisé en ce que le transistor (21) de l'amplificateur quadripôle (6) est un IGBT (21c).

8. Montage suivant l'une des revendications 1 à 7,
caractérisé en ce qu'il est utilisé comme étage amplificateur vidéo, dont la charge capacitive (4) est un tube video.

9. Montage suivant la revendication 8,
caractérisé en ce que le tube video est susceptible d'être commandé par un signal vidéo à fréquence de lignes egale à 16 kHz.

10. Montage suivant la revendication 8,
caractérisé en ce que le tube video est susceptible d'être commandé par un signal vidéo à fréquence de lignes egale à 32 kHz.
